(19) Europäisches Patentamt / European Patent Office / Office européen des brevets

(11) **EP 3 158 584 B1**

(12) **EUROPEAN PATENT SPECIFICATION**

(45) Date of publication and mention
of the grant of the patent:
**15.08.2018 Bulletin 2018/33**

(21) Application number: **15763422.1**

(22) Date of filing: **19.06.2015**

(51) Int Cl.:
***H01L 27/144*** *(2006.01)*

(86) International application number:
**PCT/IT2015/000161**

(87) International publication number:
**WO 2015/193929 (23.12.2015 Gazette 2015/51)**

(54) **RECTIFIER FOR A THZ BAND RADIATION SENSOR, IN PARTICULAR FOR IMAGING, AND CHARGE COLLECTING SYSTEM COMPRISING SAID RECTIFIER**

GLEICHRICHTER FÜR EINEN THZ-BANDSTRAHLUNGSSENSOR, INSBESONDERE ZUR ABBILDUNG, SOWIE GEBÜHRENEINZUGSSYSTEM MIT DIESEM GLEICHRICHTER

REDRESSEUR POUR CAPTEUR DE RAYONNEMENT DE BANDE THZ, EN PARTICULIER POUR L'IMAGERIE, ET SYSTÈME DE COLLECTE DE CHARGE COMPRENANT LEDIT REDRESSEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.06.2014  IT RM20140323**

(43) Date of publication of application:
**26.04.2017  Bulletin 2017/17**

(73) Proprietors:
• **Universita' Degli Studi di Roma "La Sapienza"**
  **00185 Roma (RM) (IT)**
• **LFoundry S.r.l.**
  **67051 Avezzano (IT)**

(72) Inventors:
• **PALMA, Fabrizio**
  **00185 Roma (IT)**
• **DEL MONTE, Andrea**
  **67051 Avezzano (AQ) (IT)**

(74) Representative: **Iannone, Carlo Luigi et al**
**Barzanò & Zanardo Roma S.p.A.**
**Via Piemonte 26**
**00187 Roma (IT)**

(56) References cited:
EP-A1- 2 426 739          WO-A2-03/092047
US-A1- 2011 096 447     US-B1- 6 297 984

## Description

The present invention relates to a rectifier for a sensor adapted to detect an electromagnetic radiation in the Terahertz band or THz band.

It is known that the so-called THz band sits at the interface between electronics and photonics. In particular, the THz band comprises electromagnetic signals or electromagnetic waves having a frequency varying from 300 GHz to 10 THz, with a corresponding wavelength variable from 1mm to 30μm. For this reason, the THz waves are also called sub-millimeter waves.

Imaging and spectroscopy in the THz band have a enormous potential in the application of imaging in the field of medicine, security and biotechnology. In recent years, significant progress has been made in the development of efficient emitters and receivers in the THz band.

Detecting an electromagnetic signal consists in transforming into an electrical quantity the intensity of an electromagnetic radiation having a frequency between 300 GHz and 10THz, which incides on the antenna of a receiver. Said electrical quantity is proportional to the intensity of such electromagnetic radiation and can be constant or slowly variable, depending on such intensity. Furthermore, said electrical quantity can be an electrical charge accumulated in a capacity, i.e. a potential difference across said capacity generated by the electrical charge accumulated in the capacity itself. The transformation of an electromagnetic signal into an electrical quantity is due to the fact that said antenna is an antenna mainly made of metal, with an appropriate size and shape.

The electromagnetic radiation induces an electromotive force in the antenna and an electric current, oscillating at the same frequency of the electromagnetic radiation. At the end of the antenna, in the space (so-called air gap) between the dipoles or between the single dipole and the ground plane, depending on the type of antenna, the induced electric current produces a variable electric field, and then a potential difference. Positioning a non-linear electronic element between the contacts of the air gap, the presence of a variable voltage to the frequency of the electromagnetic radiation, and therefore the presence of a variable electric field, produces a passage of electrical charge in a preferential direction. The presence of a capacity, suitably sized, in series with said non-linear electronic element produces an accumulation of such electrical charge, and consequently the establishment of a potential difference.

The process of flowing of an electrical charge in a preferential direction is usually called rectification of the electromotive force induced in the antenna. The accumulation of electrical charge due to the non-linear element corresponds to the integration in time of the information relating to the intensity of the electromagnetic radiation incident on the antenna, and it is thus an electrical quantity proportional to the intensity itself and to the integration time.

Currently, a rectifier of known type consists of a p-n semiconductor junction.

A disadvantage of said rectifier of known type is given by the fact that the potential barriers can be obtained are of approximately 0,5V-0,7V, and require potentials at least of such an order of magnitude to have a significant electric current flowing through said p-n semiconductor junction.

Another disadvantage of said rectifier of known type is that the size of the depletion zones requires crossing times by the charge carriers (electrons or holes) higher that the period of the electromagnetic radiation considered, then further reducing the possibility of obtaining a significant electric current that flowing through said p-n semiconductor junction.

A second rectifier of known type is composed of a metal-oxide-semiconductor structure.

A disadvantage of said second rectifier of known type is the fact that, to obtain a significant electrical current through said structure, is required a significant potential difference, although it is used a thickness of oxide of reduced dimensions. Even with a thickness of oxide of dimensions reduced up to the limit currently offered by the technology, i.e. about 2nm-5nm, it is required a significant potential difference, of the order of magnitude of the Volt.

Such potential difference is not realistically achievable, taking into account the sources currently available and powers of electromagnetic radiation to be detected.

US2011/0096447 discloses an electrostatic discharge protection device. It is therefore specific object ot the present invention overcoming said disadvantages, by providing a rectifier for a THz band radiation sensor, having a simple structure and configured in such a way as to generate a continuous electric current having a mean value different from zero, in the presence of a periodic electromagnetic signal.

A further object of the present invention is to provide a rectifier that allows to generate a continuous electrical current, even in the presence of a reduced potential difference between an end surface of the antenna capable of receiving said electromagnetic signal and a gathering well of charge carriers, of which said rectifier is provided.

Again object of the present invention is to provide a charge collecting system comprising said rectifier.

It is therefore specific object of the present invention a rectifier for a thz band radiation sensor, in particular for imaging, where said rectifier comprises:

- a semiconductor substrate doped p/n comprising a electrons/holes gathering well for gathering electrons/holes; said electrons/holes gathering well being arranged inside said semiconductor substrate and comprising at least a first zone doped n/p; said first zone doped n/p having an end surface;

- a metal end surface of an antenna, said antenna being capable of receiving and concentrating said electromagnetic signal;
- a layer doped p/n having a first surface and a second surface, opposite to said first surface.

In particular, a first portion of said first surface of said layer doped p/n is in contact with said end surface of said first zone doped n/p of the electrons/holes gathering well, so as to form a first metallurgical junction, and a first portion of said second surface of said layer doped p/n is in contact with said metal end surface, so as to form a second metallurgical junction. The concentration of the doping of said layer doped p/n and the concentration of the doping of said first zone doped n/p of said electrons/holes gathering well are such that said first metallurgical junction has a first potential barrier inside and the work function of the metal of said metal end surface is selected such that it is equal to that of a semiconductor doped n/p and such that said second metallurgical junction has a second potential barrier inside.

Said first metallurgical junction and said second metallurgical junction form a double metallurgical junction n-p-n/p-n-p with a double potential barrier composed of said first potential barrier and said second potential barrier, where said double metallurgical junction n-p-n/p-n-p comprises a first depletion zone, and a second depletion zone, in contact with said first depletion zone along a line of contact, disposed within said layer doped p/n. Said first depletion zone has a thickness greater than the thickness of the second depletion zone; said first potential barrier is associated with said first depletion zone, and said second potential barrier is associated with said second depletion zone.

Said layer doped p/n is dimensioned in such a way that said double potential barrier has a value such as to allow said layer doped p/n being completely deprived of holes/electrons, so that, when a variable electric field is induced by said electromagnetic signal received by said antenna, said double metallurgical junction n-p-n/p-n-p is subjected to said variable electric field, and a first potential difference and a second potential difference are generated, through the first depletion zone and through the second depletion zone respectively, where each potential difference is proportional to the thickness of the respective depletion zone and is added algebraically to the respective potential barrier so that:

when said first potential difference is negative/positive, the first potential barrier is reduced in absolute value of a value equal to the first potential difference and a first amount of electrons/holes moves in a first direction, from the first zone doped n/p of the electrons/holes gathering well to the metal end surface, and

when said second potential difference is positive/negative, the second potential barrier is reduced in absolute value by a value equal to the second potential difference and a second amount of electrons/holes moves in a second direction, opposite the first direction, from the metal end surface to the first zone doped n/p of the electrons/holes gathering well.

The work function of the metal of said metal end surface and the concentrations of the doping of said layer doped p/n and of said first zone doped n/p are such that said depletion zones are deformed asymmetrically and that said first amount of electrons/holes is different from said second amount of electrons/holes, so as to generate a continuous electric current induced by said electromagnetic signal received by said antenna.

According to the invention, the second metallurgical junction is dimensioned in such a way that its orthogonal projection on said first surface of said layer doped p/n is contained in the first metallurgical junction.

Again according to the invention, said first depletion zone comprises a first portion extending from said first surface of said layer doped p/n inside said first zone doped n/p of said electrons/holes gathering well, and a second portion extending from said first surface of said layer doped p/n inside the layer doped p/n itself, up to said line of contact. Furthermore, said second depletion zone extends substantially from said second surface of said layer doped p/n towards the inside of said layer doped p/n, up to said line of contact.

It is preferable that the work function of the metal of said metal end surface has a value between 4,2-4,4eV.

It is also preferable that the metal of said metal end surface is selected from the following group of metals: titanium, molybdenum, bismuth, vanadium.

Furhtermore, it is possible to provide that a dielectric layer is interposed between the metal end surface and the second surface of said layer doped p/n, in order to ensure the conduction between said metal end surface and said layer doped p/n, and to maintain the position of the Fermi level of said metal end surface until the physical contact with said second metallurgical junction.

Said dielectric layer can be an silicon oxide layer, where said silicon has an atomic concentration between 35% and 45%.

In particular, said first zone doped n/p of said electrons/holes gathering well can have a doping between $10^{15}$ and $10^{17}$ cm$^{-3}$.

Furthermore, said layer doped p/n can have a doping between $10^{17}$ and $10^{19}$ cm$^{-3}$.

It is also object of the present invention a charge gathering system comprising a rectifier above mentioned, where the semiconductor substrate is connected to a ground and the electrons/holes gathering well of said rectifier comprises a second zone doped n/p, arranged in contact with said first zone doped n/p, and where said second zone doped n/p has a doping higher than the doping of said first zone doped n/p.

Said system comprises a MOS transistor adapted to introduce electrons/holes in said electrons/holes gathering well; said MOS transistor having a drain consisting of a well doped n/p, disposed within said semiconductor substrate, a source consisting of at least one end portion of said second zone doped n/p of said electrons/holes gathering well, and a gate disposed straddling between said drain and said source and separated from said semiconductor substrate by means of a silicon oxide layer.

Said system is configured in such a way that, when the MOS transistor is turned on, an amount of electrons/holes passes, for thermodynamic effect, from the well doped n/p constituting the drain of said MOS transistor to said second zone doped n/p of said electrons/holes gathering well, so that the amount of electrons/holes in said well doped n/p is decreased of the same amount of electrons/holes, and that, regardless of the fact that said MOS transistor is turned on, at least a part of said amount of electrons/holes passes, for thermodynamic effect, from said second zone doped n/p to said first zone doped n/p of said electrons/holes gathering well.

In particular, the drain of said MOS transistor is connected to a first device or potential restoring device, configured to restore the amount of electrons/holes in said electron/electrons gathering well, and to a second device or potential variation reading device, configured to read the potential variation between said well doped n/p and said ground, and in that said first device and said second device are controlled by a control and processing unit, configured to periodically read said potential variation through said second device and restore the amount of electrons/holes in said electrons/holes gathering well through said first device. Said control and processing unit being connected with said second device.

More particularly, said first device comprises a MOS transistor, powered by a first voltage, and said second device comprises a first MOS transistor, powered by a second voltage, where said second voltage is in absolute value greater than said first voltage, and a second MOS transistor, where the drain of said second MOS transistor is connected to the source of said first MOS transistor and the source of said second MOS transistor is connected to said control and processing unit via a bus.

The drain of said MOS transistor adapted to introduce electrons/holes in said electrons/holes gathering well, composed of said well doped n/p, is connected to the source of said MOS transistor of said first device and to the gate of said first MOS transistor of said second device.

It is preferable that said second zone doped n/p has a doping between $10^{17}$ and $10^{19} \mathrm{cm}^{-3}$.

It is also preferable that said well doped n/p constituting the drain of said MOS transistor has a doping between $10^{17}$ and $10^{19}$ cm$^{-3}$.

Furthermore, said system can comprise a first metal layer, on which a terminal is arranged to allow a microwave generator to be applied, and a plurality of second metal layers, on each of which a respective terminal, connected to said ground, is arranged. Said first metal layer and said second metal layers are arranged on a dielectric layer arranged on said semiconductor substrate.

In particular, said first metal layer is connected, through a first metallic element, to said metal end surface, and each of said second metal layers is connected, through a respective second metallic element, to a respective ohmic contact, arranged in contact with said layer doped p/n. Said system comprises a further ohmic contact, arranged in contact with the well doped n/p constituting the drain of said MOS transistor, on which a further terminal is arranged to allow the application of a current meter for measuring the current due to the passage of electrons/holes from said well doped n/p towards said electrons/holes gathering well, when said MOS transistor is turned on.

The present invention will be now described, for illustrative, but not limitative purposes, according to its embodiments, making particular reference to the enclosed figures, wherein:

Figure 1 shows schematically a sectional view of a first embodiment of a charge gathering system, comprising a first embodiment of a rectifier for a sensor of electromagnetic signal in band THz, according to the invention;

Figure 2 shows in detail the zone of the rectifier in which a portion of a first surface of a layer doped p is in contact with a first zone doped n of a electrons gathering well and a metal end surface of an antenna is in contact with a portion of a second surface of the same layer doped p;

Figure 3 schematically shows the two depletion zones present in the double metallurgical junction n-p-n of the rectifier, with the charges distributed within a part of the first zone doped n of the electrons gathering well, the layer doped p, and in the proximity of the metal end surface of the antenna, so as to generate a double potential barrier between the metal end surface of the antenna and the first zone doped n of the of electrons gathering well;

Figure 4 schematically shows a charge reading and restoring circuit for reading the change of potential between the drain of a MOS transistor of the electrical charge gathering system and ground, and for restoring the quantity of electrical charge inside of the electrons gathering well, where said MOS transistor has the drain connected to said circuit and the source connected to a diode that represents the junction p-n between said electrons gathering well and the semiconductor substrate;

Figure 5 shows a second embodiment of the gathering system, comprising a second embodiment of the rectifier configured to verify the efficiency of the rectifier.

In the figures, similar elements are indicated with the same reference numbers.

In the following a preferred embodiment of the rectifier for a THz band radiation according to the invention will be disclosed, in which the monolithic integrated circuit has specific types of doping, with an indication of concentrations of doping are purely exemplifying and not limiting, unless expressed otherwise. However, it should be noted that other embodiments of the rectifier according to the invention may have a types of doping reversed with respect to those illustrated for the preferred embodiment, always remaining within the scope of protection of the present invention.

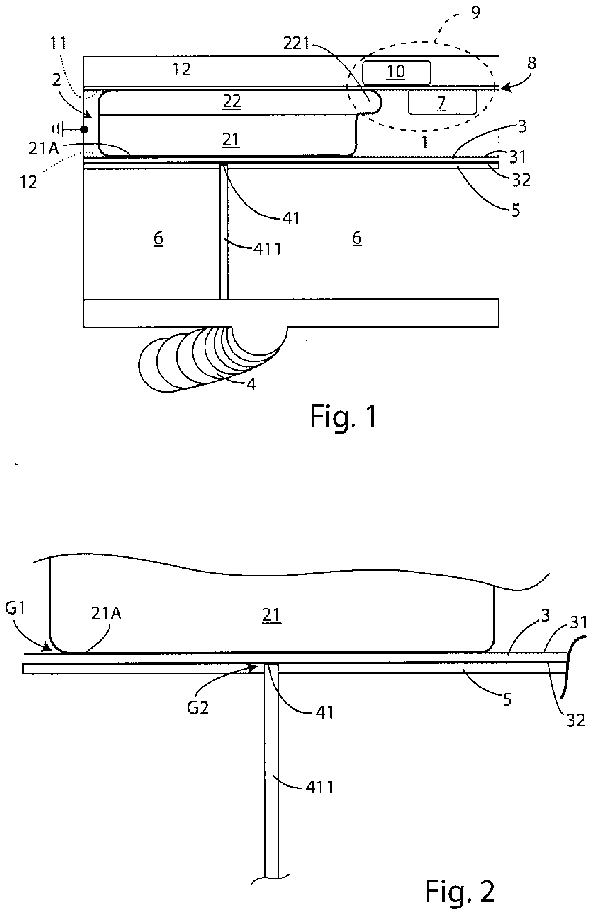

With particular reference to Figures 1-2, an embodiment of a rectifier for a sensor of electromagnetic signal in band THz, i.e. an electromagnetic signal having a frequency between 300Ghz and 10THz.

Said rectifier comprises:

- a semiconductor substrate 1 doped p, said semiconductor substrate comprising a electrons gathering well 2, where said well is arranged inside said semiconductor substrate 1 and comprises at least a first zone doped n 21, and said first zone doped n 21 comprises an end surface 21A,
- at least one metal end surface 41 of conductore 411 of an antenna 4, where said antenna is capable of receiving and concentrating an electromagnetic signal,
- a layer doped p 3 having a first surface 31 and a second surface 32, opposite to said first surface 31.

In particular a first portion of said first surface 31 of the layer doped p 3 is in contact with said end surface 21A of said first zone doped n 21 of the gathering well 2 so as to form a first metallurgical junction G1, and a first portion of said second surface 32 of the layer doped p 3 is in contact with said metal end surface 41 of said antenna 4 so as to form a second metallurgical junction G2. Said second metallurgical junction G2 is faced to a portion of said first metallurgical junction G1.

In particular, the second metallurgical junction G2 is dimensioned in such a way that its orthogonal projection on the first surface 31 of said layer doped p 3 is contained in the first metallurgical junction G1.

As a result, the first portion of said first surface 31 and the first portion of said second surface 32 are faced to each other, and each of them has an area at least equal to that of said metal end surface 41 of said antenna 4.

As it is known the metallurgical junction means the interface between two materials with different electronic properties, in physical contact with one another.

In particular, the metallurgical junction can be the interface between two semiconductor materials, each of them has a respective doping.

Furthermore, the metallurgical junction means the physical or material transition interface in any type of solid-state junction.

More particularly, a second portion of said first surface of the layer doped p 3, complementing said first portion, is in contact with said semiconductor substrate, and a second portion of said second surface 32 of said layer doped p, complementary to said first portion, is in contact with a first dielectric layer 5, preferably an silicon oxide layer.

Said first dielectric layer 5 is in contact with a second dielectric layer 6. In order to allow the metal end surface 41 of the conductor 411 of said antenna 4 to contact the layer doped p 3, said first dielectric layer has a first cavity and said second dielectric layer has a second cavity, positioned in correspondence of said first cavity.

The semiconductor substrate 1 has a first surface 11, and a second surface 12, opposite to said first surface 11, and the first surface 31 of the layer doped p 3 has the same dimensions of the second surface 12 of the semiconductor substrate 1. In figure 1, the two surfaces 11, 12 of the substrate have been represented by a dotted line for better distinguish them from the surfaces of the layers with which the semiconductor substrate 1 is in contact with.

Furthermore, the second surface 32 of the layer doped p 3 is greater than the metal end surface 41 of the conductor 411 of the antenna 4.

The concentration of the doping of said layer doped p 3 and the concentration of the doping of the first zone doped n 21 of the electrons gathering well 2 are such that said first metallurgical junction G1 is a rectifying junction.

Furthermore, the work function of the metal of said metal end surface 41 of the antenna 4 is selected such that it is equal to that of a semiconductor doped n and such that said second metallurgical junction is a rectifying junction.

Rectifying junction means a junction having inside a potential barrier so that to produce a continuous electric current flowing through the junction itself in a preferred direction, when a variable voltage, even with a mean value equal to zero, is applied on said junction.

In particular, it is referred to a structure achieved by the contact between two semiconductor materials or between a semiconductor material and a metal material, where the transport of majority charge carriers is influenced by the presence of a potential barrier.

The potential barrier is generated by the different position of the Fermi level in each of the two original materials.

If a voltage, external to the junction, is applied on the junction itself, said potential barrier is altered and an electric current flowing through said junction is generated.

The trend of said electric current depends on the applied voltage in a non-linear manner. According to theory referred to the semiconductor junctions, it is an exponential dependence.

If the applied voltage is a variable voltage varying in a periodic way with zero mean value, a continuous electric current having a mean value different from zero is generated, due to the non-linear dependency of the electric current from the applied voltage.

Said electric current is also called rectifying electric current.

Consequently, the first metallurgival junction has a first potential barrier $V_{Z1}$ inside and the second metallurgical junction has a second potential barrier $V_{Z2}$ inside.

Thus the first metallurgical junction G1 and the second metallurgical junction G2 form a double metallurgical junction n-p-n having inside a double potential barrier composed of said first potential barrier and said second potential barrier.

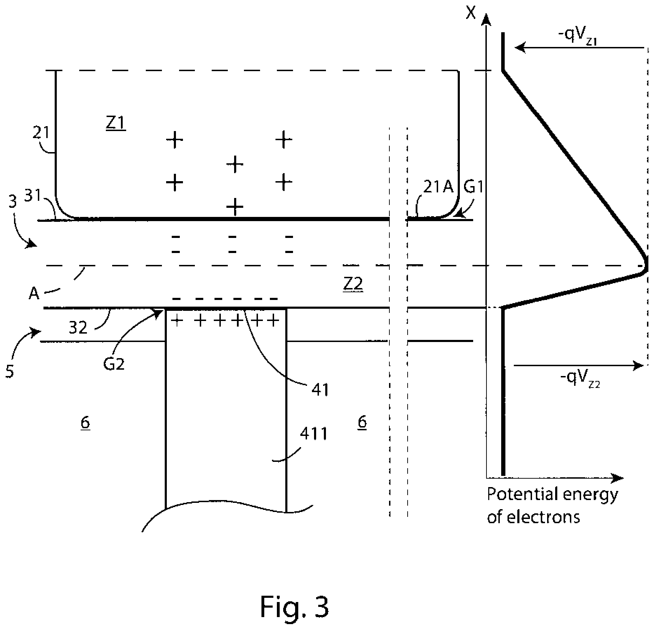

The double metallurgical junction n-p-n comprise a first depletion zone Z1, and a second depletion zone Z2, contiguous to said first depletion zone, where said first depletion zone Z1 has thickness greater that the thickness of the second depletion zone Z2 (figure 3).

Furthermore, the second depletion zone Z2 is in contact with the first depletion zone Z1 along a line of contact A, disposed within said layer doped p 3.

In particular, the first depletion zone Z1 has a first portion extending from the first surface 31 of said layer doped p 3 inside the first zone doped n 21 of the electrons gathering well 2, and a second portion extending from the first surface 31 of said layer doped p 3 inside the layer doped p 3 itself.

The thickness of the second portion of the first depletion zone Z1 is negligible with respect to that of the first portion of the first depletion zone itself. This is due to the fact that the thickness of the layer doped p 3 is significantly lower than that of the first zone doped n 21, preferably by a factor of between 100 and 1000. Furthermore, due to the different doping between the first zone doped n 21 of the electrons gathering well 2 and the layer doped p 3, the thickness of the second portion of the first depletion zone Z1 is more negligible with respect to the first portion of the depletion zone Z1. For this reason, the second portion of said first depletion zone Z1 can be neglected, and it is possible to state that the first depletion zone Z1 extends substantially from the first surface 31 of said layer doped p 3 toward the inside of the first zone doped n 21 of the electrons gathering well 2.

The second depletion zone Z2 has a thickness extending substantially from the second surface 32 of the layer doped p 3 inside the layer doped p 3 itself, because it cannot extend beyond the metal end surface 41 of the antenna 4. This is due to the metal nature of the antenna 4.

As already said, the double metallurgical junction n-p-n has a double potential barrier inside composed of said first potential barrier $V_{Z1}$ and said second potential barrier $V_{Z2}$, where said first potential barrier $V_{Z1}$ is associated with to the first depletion zone Z1, and said second potential barrier $V_{Z2}$ is associated with the second depletion zone Z2. In ballance, the two potential barriers $V_{Z1}$, $V_{Z2}$ are equal in magnitude and opposite in sign.

In figure 3, the potential energy of the electrons is represented. The double potential barrier has a peak and the line of contact A between the two depletion zones is drawn in correspondence of such peak.

According to the invention, said layer doped p 3 is dimensioned in such a way that said double potential barrier has a value such as to allow said layer doped p to be completely deprived of holes, (i.e. majoritary charge carriers).

In the case where a variable electric field is induced by an electromagnetic signal received by said antenna 4, said double metallurgical junction n-p-n is subjected to said variable electric field, and a first potential difference $\Delta V_{Z1}$, through the first depletion zone Z1, and a second potential difference $\Delta V_{Z2}$, through the second depletion zone Z2.

Each potential difference $\Delta V_{Z1}$, $\Delta V_{Z2}$ is proportional to the thickness of the respective depletion zone Z1, Z2. Consequently, due to the different thicknesses of the depletion zones, the first potential difference $\Delta V_{Z1}$ is greater than the second potential difference $\Delta V_{Z2}$.

Each potential barrier associated with the respective depletion zone is modified.

The potential differences $\Delta V_{Z1}$, $\Delta V_{Z2}$ have the same sign and are added algebraically to the respective potential barriers $V_{Z1}$, $V_{Z2}$ of the depletion zones Z1, Z2.

If the potential differences $\Delta V_{Z1}$, $\Delta V_{Z2}$ are negative, the first potential barrier $V_{Z1}$, associated with the first depletion zone Z1, is reduced in absolute value of a value equal to the first potential difference $\Delta V_{Z1}$ and a first amount of electrons moves in a first direction, from the first zone doped n 21 of the electrons gathering well 2 to the metal end surface 41 of the antenna 4.

On the contrary, the second potential barrier associated with the second depletion zone Z2 increases in absolute value of a value equal to a second potential difference $\Delta V_{Z2}$, preventing the passage of electrons in the direction opposite to said first direction.

If the potential differences $\Delta V_{Z1}$, $\Delta V_{Z2}$ are positive, the second potential barrier $V_{Z2}$ associated with to the second depletion zone Z2 is reduced in absolute value of a value equal to the second potential difference $\Delta V_{Z2}$ and a second amount of electrons mobes in a second direction, opposite to said first direction, i.e. from the metal end surface 41 of the antenna 4 to the first zone doped n 21 of the electrons gathering well 2.

On the contrary, the first potential barrier $V_{Z1}$, associated with said depletion zone Z1, increase in absolute value of a value equal to the first potential difference $\Delta V_{Z1}$, preventing the passage of electrons in the direction opposite to said second direction.

In the example beig disclosed, the conventional sign of the potential difference was assumed concordant with the axis X of Figure 3.

Again according to the invention, the work function of the metal of the metal end surface 41, and the dopings of the layer doped p 3 and the first zone doped n 21 of the electrons gathering well 2 are such that said first depletion zone Z1 and said second depletion zone Z2 are deformed asymmetrically.

In this way, in presence of a variable electric field, alternately positive and negative, the first amount of electrons which moves in the first direction (i.e. from the first zone doped n 21 of the electrons gathering well 2 toward the end surface 41 of the antenna) is different from the second amount of electrons which moves in a second direction, opposite to said first direction (i.e. from the end surface 41 of the antenna 4 toward the first zone doped n 21 of the electrons gathering well 2).

With reference to an electric field variable in a sinusoidal manner, the first amount of electrons, i.e. the electrons passing from the first zone doped n 21 of the electrons gathering well 2 to the antenna 4 in a half period of the electromagnetic signal (namely when the potential induced by the electromagnetic signal is positive on said antenna 4 with respect to the potential on said electrons gathering well 2), is greater of the second amount of electrons, i.e. the electrons passing from the antenna 4 to said first zone doped n 21 of the electrons gathering well 2 in a consecutive half period (namely when the potential induced by the electromagnetic signal is positive on said electrons gathering well 2 with respect to the potential on said antenna 4).

The passage of two different amounts of electrons produce a continuous electric current or rectifying electric current induced by the electromagnetic signal received by the antenna 4 by means of the antenna itself. This results in a change of charge accumulated in the electrons gathering well 2.

In particular, in the embodiment being disclosed, the layer doped p 3 is dimensioned in such a way that it has dimensions greater than the dimensions of the end surface 21A of the first zone doped n 21 of the electrons gathering wel 2 and that dimensions of the metal end surface 41 of the antenna 4. The metal end surface 41 of the antenna 4, in turns, has dimensions reduced with respect to those of the conductor 411 of the antenna 4 itself, the latter being dimensioned to ensure a mechanical resistance. It is preferable that said end surface 41 has dimensions between 10 and 300nm depending on technology with which said end surface is made of. The dimensions of the conductor 411 of the antenna 4 are between 1 and 10$\mu$m.

Furthermore, said semiconductor substrate 1 doped p has a value of concentration of doping $p_0$ such that to fulfil the relationship;

$$\omega_R = \frac{q\mu_p p_0}{\varepsilon_S}$$

where $q$ is the electrical charge, $\mu_p$ is a mobility of charge carriers of the semiconductor substrate 1, and $\varepsilon_S$ is the dielectric constant of the semiconductor material of the substrate 1, and $\omega_R$ is greater or equal to the frequency to be detected.

The value of concentration of doping $p_0$ is preferable greater than $6\cdot10^{16}$ cm$^{-3}$.

Said first zone doped n 21 of the electrons gathering well has a low doping, namely a doping between $10^{15}$ and $10^{17}$ cm$^{-3}$.

Said layer doped p 3 is strongly doped, namely a doping between $10^{17}$ and $10^{19}$ cm$^{-3}$.

It is preferable that the work function of the metal of said metal end surface has a value between 4,2-4,4 eV.

Particularly, with reference to the ranges of dopings values above mentioned, it is preferable that the work function of said metal has a value equal to 4,33 eV to form a double potential barrier between the metal end surface 41 and the layer doped p 3.

Furhtermore, the metal of the metal end end surface 41 is selected from the following group of metals: titanium, molybdenum, bismuth, vanadium.

In a variant, not shown in the figures, it is possible to provide a dielectric layer interposed between the metal end surface 41 of the antenna 4 and the portion of the second surface 32 of said layer doped np 3, with which said end surface 41 is in contact.

Such dielectric layer is able to ensure the conduction of charge between said metal end surface 41 and said layer doped p 3 and to maintain the position of the Fermi level of said metal end surface until the contact with the second metallurgival junction G2.

It is preferable that such dielectric layer is oxide layer full of silicon; which means with a silicon having an atomic concentration between 35% and 45%.

The invention relates to a charge gathering system comprising a rectifier as above disclosed.

In particular, the electrons gathering well 3 comprises a second zone doped n 22 in contact with said first zone doped n 21.

Said second zone doped n 22 has a doping greater than doping of said first zone doped n 21. Preferable, said second zone doped n 22 has a doping between $10^{17}$ and $10^{19}$

Particularly, said second zone doped n 22 is spaced from said first metallurgical junction G1.

At least one end portion 221 of said second zone doped n 22 constitutes the source of a MOS transistor, indicated with the reference number 9, adapted to introduce charge carriers (i.e. electrons in the specific case) in said electrons gathering well 2.

Said MOS transistor 9 has a drain consisting of a well doped n 7, positioned within the semiconductor substrate 1, and a gate consisting of polycrystalline silicon layer 10 (or in alternative consisting of a metal terminal) disposed straddling between said at least one end portion 221 constituting the source of said MOS transistor 9 and said well doped n 7 constituting the drain of the MOs transistor itself. According the known MOS structure, said gate is separated by the semiconductor substrate 1 by means of a silicon oxide layer 8 and is positioned within a third dielectric layer 12 that is in contact whith said silicon oxide layer 8.

The well doped 7 which consitutes the drain of the MOS transistor 9 has a doping preferably between $10^{17}$ and $10^{19}$ cm$^{-3}$.

Furthermore, the drain of said MOS transistor 9 (consituted of said well doped n 7) is connected to a potential reading and restoring circuit C for reading the potential variation between said drain and ground (i.e. the ground to which said semiconductor substrate 1 is connected) and for restoring the amount of electrical charge carriers (i.e. electrons in the specific case) within the drain itself. In other words, the potential variation which is read is the potential difference of the stray capacitance of the well doped n 7 consituting of the drain of the MOS transistor 9 and the ground to which said semiconductor substrate 1 is connected.

Said circuit C comprises a first device D1 or potential restoring device, configured to restore electrical charge carrier within the well doped n 7 which constitutes the drain of the MOS transistor 9, and a second device D2 or potential variation reading device configured to read the potential variation between said drain and ground, as well as a control and processing unit 19 to control said first device D1 and said second device D2.

Particualrly, the drain of said MOS transistor 9 is connected to said first device D1 and said second device D2. The first device D1 and the second device D2 are controlled by said control and processing unit 19, connected to said second device D2, configured to read periodically such potential variation through said second device D2 and restore the number of charge carriers (i. e. electrons in the specific case) within said well doped n 7 which constitutes the drain of the MOS transistor 9, through said first device D1.

More particularly, said first device D1 comprises a MOS transistor 14 powered by a first voltage $V_{low}$.

The drain of the MOS transistor 9 is connectred to the source of the MOS transistor 14 of said first device D1.

The second device D2 comprises a first MOS transistor 15 powered by a second voltage $V_{dd}$, greater than said first voltage $V_{low}$, and a second MOS transistor 16, the drain of which is connected to the source of said first MOS transistor 15 and the source of which is connected to said processing and control unit 19 via a bus 17.

The drain of the MOS transistor 9 is connected to the gate of the first transistor 15 of said second device D2.

The contacts of the MOS transistor 9, the MOS transistor 14 of the first device D1 and of the MOS transistors 15, 16 of the second device D2 are positioned on said third dielectric layer 12.

The electrical connections of the circuit C and the bus 17 connecting said circuit to said processing and control unit 19 are distributed on a plurality of metallization planes, separated by dielectric strates (not shown).

Furthermore, the source of the MOS transistor 9 (consisting of at least one end portion 221 of the first zone doped n 21 of the electrons gathering well 2) is connected to a diode indicated with the reference number 18 which represents the junction p-n between the electrons gathering well 2 and the semiconductor substrate 1.

The charge gathering system is configured in such a way that, when the MOS transistor 9 is turned on, the charge moves, due to a thermodynamic effect, from the well doped n 7 constituting the drain of the MOS transistor 9 to said second zone doped n 22 of the electrons gathering well 2 and that the charge reduction in said well doped n 7 is detected by said second device D2 and that, irrespective whether the MOS transistor 9 is turned on, a part of said charge moves/passes, due to a thermodynamic effect, from said second zone doped n 22 of the electrons gathering well 2 to said first zone doped n 21 of the electrons gathering well 2. The amount of charge which has decreased in said well doped n 7 is equal to the amount of charge which reached the second zone doped n 22.

A voltage equal to the second supply voltage $V_{dd}$ is applied on the gate in order to activate the MOS transistor.

In other words, the MOS transistor 9 is turned on by means of the application of a positive voltage applied on its gate. This produces a passage of charge from the well doped n 7 constituting the drain of the MOS transistor 9 toward the second zone doped n 22 of the electrons gathering well 2.

The variation of potential on the well doped n 7 constituting the drain of the MOS transistor 9, due to the passage of charge, is read from the first MOS transistor of the second device D2 and applied on the bus by the latter by means of the second MOS transistor 16 of the second device D2, so that the information about such potential variation reaches said processing and control unit 19.

After reading the passage of charge, the MOS transistor 14 of the first device D1 is turned on by said processing and control unit 19 and the value of the voltage on the drain of the MOS transistor 9 is restored to the original value, i.e. to the value of the first supply voltage $V_{low}$.

The first device D1 is adapted to restore the level of charge of said well doped n 7 constituting the drain of the MOS transistor 9. This is due to the fact the processing and control unit 19, turning on the MOS transistor 14 of the first device D1, applies on the well doped n 7 constituting the drain of the MOS transistor 9 said first voltage $V_{low}$, at the beginning of each period of integration of charge.

Said first voltage $V_{low}$ has a value preferable between 0,2 and 0,5 times the second supply voltage $V_{dd}$.

Said circuit C is adapted to give to the processing and control unit 19 the value of voltage of the well doped n 7 constituting the drain of the MOS transistor 9, which is increased due to the passage of electrons from the well doped n 7 to the electrons gathering well 2, at the end of the period of integration.

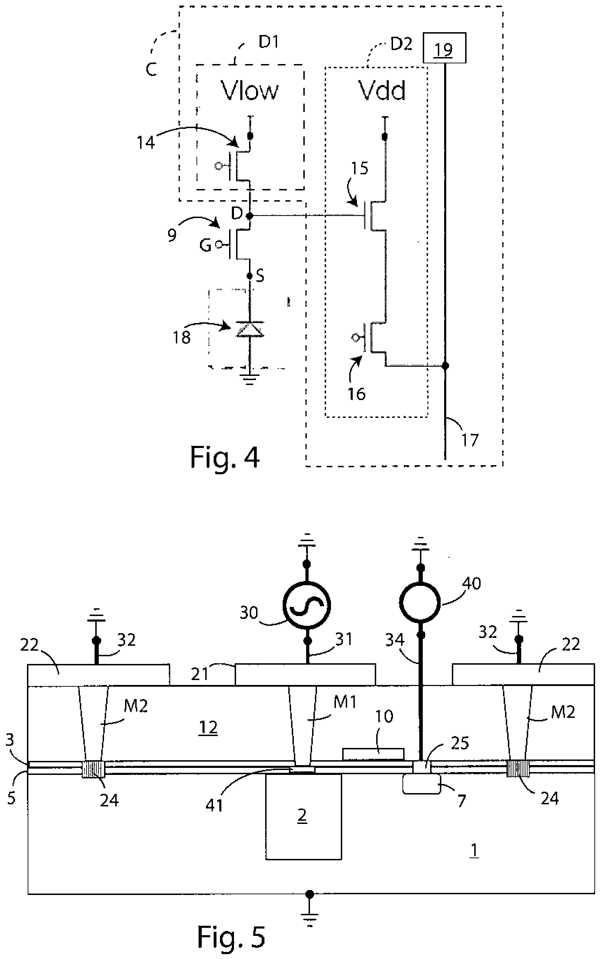

In figure 5 a second embodiment of the charge gathering system is shown, where it comprises a second embodiment of the rectifier.

Said system comprises a first metal layer 21 provided with a terminal 31 to allow a microwave generator 30, connected to ground, and a plurality of second metal layer 22, each of them is provided with a respective terminal 32, connected to said ground.

Said first metal layer 21 and said second metal layer 22 are arranged on said third dielectric layer 12, positioned on said semiconductor substrate 1.

Said first metal layer 21 is connected, through a first metal element M1, to the metal end surface 41, and each of said second metal layer 22 is connected, through a respective metal element M2, to a respective ohmic contact 24, in contact with the layer doped p 3.

Said system comprises a further ohmic contact 25, in contact with the well doped n 7 constituting the drain of the MOS transistor 9, and provided with a further terminal 34 to allow the application of a current meter 40 for measuring the current due to the passage of electrical charges from the well doped n 7 constituting the drain of the MOS transistor 9 toward the electrons gathering well 2, when said MOS transistor 9 is turned on.

Said current meter 40 has a first terminal to be connected to said further terminal 34 and a second terminal connected to said ground.

Furthermore, said current meter 40 comprises a filter to prevent the voltage applied to the microwave generator 30 from reaching the current meter itself.

When a voltage is applied on the terminal 31 through the microwave generator 30, a rectifying electric current is produced, so that an amount of electrons moves from the first zone doped n 21 of the electrons gathering well 2 to the ground.

As previously said, the amount of electrical charge can be restored thanks to the passage of electrical charges which from the well doped n 7 constituting the drain of the MOS transistor 9 reach the electrons gathering well 2, when said MOS transistor 9 is turned on by means the application of a voltage on its gate equal to the second supply voltage Vdd of the first MOS transistor 15 of the second device D2. Consequently the current meter 40 measures the current due to the passage of said electrical charges and the efficiency of the rectifier is evaluated depending on the value of the current which is measured.

Advantageously, as alluded, the rectifier object of the invention has a simple structure, where some physical zones, such as the semiconductor substrate, the first zone doped n/p of the electrons/holes gathering well and the well doped n/p contituting the drain of the MOS transistor 9, usually used in the integrated circuits constituting the image detectors in the visible, constitute structural parts of the rectifier itself, so that said zones are capable of operating as detectors of electromagnetic radiation in the THz band.

A further advantage is that there is no discontinuity between the antenna and the rectifier, so that the electric field present in the air gap of the antenna is maximized and produces a rectifying current, because it acts on the rectifier.

The present invention has been described for illustrative, but not limitative purposes with reference to its preferred embodiments, but it is well evident that one skilled in the art can introduce variants and/or modifications to the same, without departing from the relevant scope as defined in the enclosed claims.

## Claims

1.  Rectifier for a sensor of electromagnetic signal, said electromagnetic signal having a frequency between 300Ghz and 10THz, said rectifier comprising:

    - a semiconductor substrate (1) doped p/n comprising a electrons/holes gathering well (2) for gathering electrons/holes; said electrons/holes gathering well (2) being arranged inside said semiconductor substrate (1) and comprising at least a first zone doped n/p (21); said first zone doped n/p (21) having an end surface (21A);
    - a metal end surface (41) of an antenna (4), said antenna being capable of receiving and concentrating said electromagnetic signal;
    - a layer doped p/n (3) having a first surface (31) and a second surface (32), opposite to said first surface (31); wherein:

        a first portion of said first surface (31) of said layer doped p/n (3) is in contact with said end surface (21A) of said first zone doped n/p (21) of the electrons/holes gathering well (2), so as to form a first metallurgical junction (G1), and
        a first portion of said second surface (32) of said layer doped p/n (3) is in contact with said metal end surface (41), so as to form a second metallurgical junction (G2);

    where the concentration of the doping of said layer doped p/n (3) and the concentration of the doping of said first zone doped n/p (21) of said electrons/holes gathering well (2) are such that said first metallurgical junction (G1) has a first potential barrier ($V_{Z1}$) inside and the work function of the metal of said metal end surface (41) is selected such that it is equal to that of a semiconductor doped n/p and such that said second metallurgical junction (G2) has a second potential barrier ($V_{Z2}$) inside;
    in that
    said first metallurgical junction (G1) and said second metallurgical junction (G2) form a double metallurgical junction n-p-n/p-n-p with a double potential barrier composed of said first potential barrier ($V_{Z1}$) and said second potential barrier ($V_{Z2}$), where said double metallurgical junction n-p-n/p-n-p comprises a first depletion zone (Z1), and a second depletion zone (Z2), in contact with said first depletion zone (Z1) along a line of contact (A), disposed within said layer doped p/n (3), said first depletion zone (Z1) having a thickness greater than the thickness of the second depletion zone (Z2); said first potential barrier ($V_{Z1}$) being associated with said first depletion zone (Z1), and said second potential barrier ($V_{Z2}$) being associated with said second depletion zone (Z2);

in that

said layer doped p/n (3) is dimensioned in such a way that said double potential barrier has a value such as to allow said layer doped p/n (3) being completely deprived of holes/electrons, so that, when a variable electric field is induced by said electromagnetic signal received by said antenna (4), said double metallurgical junction n-p-n/p-n-p is subjected to said variable electric field, and a first potential difference ($\Delta V_{Z1}$) and a second potential difference ($\Delta V_{Z2}$) are generated, through the first depletion zone (Z1) and through the second depletion zone (Z2) respectively, where each potential difference ($\Delta V_{Z1}$, $\Delta V_{Z2}$) is proportional to the thickness of the respective depletion zone (Z1, Z2) and is added algebraically to the respective potential barrier ($V_{Z1}$, $V_{Z2}$) so that

when said first potential difference ($\Delta V_{Z1}$) is negative/positive, the first potential barrier ($V_{Z1}$) is reduced in absolute value of a value equal to the first potential difference ($\Delta V_{Z1}$) and a first amount of electrons/holes moves in a first direction, from the first zone doped n/p (21) of the electrons/holes gathering well (2) to the meta! end surface (41), and

when said second potential difference ($\Delta V_{Z2}$) is positive/negative, the second potential barrier ($V_{Z2}$) is reduced in absolute value by a value equal to the second potential difference ($\Delta V_{Z2}$) and a second amount of electrons/holes moves in a second direction, opposite the first direction, from the metal end surface (41) to the first zone doped n/p (21) of the electrons/holes gathering well (2);

the work function of the metal of said metal end surface (41) and the concentrations of the doping of said layer doped p/n (3) and of said first zone doped n/p (21) being such that said depletion zones (Z1, Z2) are deformed asymmetrically and that said first amount of electrons/holes is different from said second amount of electrons/holes, so as to generate a continuous electric current induced by said electromagnetic signal received by said antenna (4).

2. Rectifier according to the preceding claim, **characterized in that** said second metallurgical junction (G2) is dimensioned in such a way that its orthogonal projection on said first surface (31) of said layer doped p/n (3) is contained in the first metallurgical junction (G1).

3. Rectifier according to any one of the preceding claims, **characterized in that** said first depletion zone (Z1) comprises a first portion extending from said first surface (31) of said layer doped p/n (3) inside said first zone doped n/p (21) of said electrons/holes gathering well (2), and a second portion extending from said first surface (31) of said layer doped p/n (3) inside the layer doped p/n (3) itself, up to said line of contact (A), and **in that** said second depletion zone (Z2) extends substantially from said second surface (32) of said layer doped p/n (3) towards the inside of said layer doped p/n (3), up to said line of contact (A).

4. Rectifier according to any one of the preceding claims, **characterized in that** the work function of the metal of said metal end surface (41) has a value between 4,2-4,4eV.

5. Rectifier according to any one of the preceding claims, **characterized in that** the metal of said metal end surface (41) is selected from the following group of metals: titanium, molybdenum, bismuth, vanadium.

6. Rectifier according to any one of the preceding claims, **characterized in that** a dielectric layer is interposed between the metal end surface (41) and the second surface (32) of said layer doped p/n (3), in order to ensure the conduction between said metal end surface (41) and said layer doped p/n (3), and to maintain the position of the Fermi level of said metal end surface (41) until the physical contact with said second metallurgical junction (G2).

7. Rectifier according to the preceding claim, **characterized in that** said dielectric layer is an silicon oxide layer; said silicon having an atomic concentration between 35% and 45%.

8. Rectifier according to any one of the preceding claims **characterized in that** said first zone doped n/p (21) of said electrons/holes gathering well (2) has a doping between $10^{15}$ and $10^{17} cm^{-3}$.

9. Rectifier according to any one of the preceding claims, **characterized in that** said layer doped p/n (3) has a doping between $10^{17}$ and $10^{19} cm^{-3}$.

10. Charge gathering system comprising a rectifier according to any one of the preceding claims, **characterized in that** said semiconductor substrate (1) is connected to a ground and **in that** the electrons/holes gathering well (2) of said rectifier comprises a second zone doped n/p (22), arranged in contact with said first zone doped n/p (21), where said second zone doped n/p (22) has a doping higher than the doping of said first zone doped n/p (21);

said system further comprising:

a MOS transistor (9) adapted to introduce electrons/holes in said electrons/holes gathering well (2); said MOS transistor (9) having a drain consisting of a well doped n/p (7), disposed within said semiconductor substrate (1), a source consisting of at least one end portion (221) of said second zone doped n/p (22) of said electrons/holes gathering well (2), and a gate disposed straddling between said drain and said source and separated from said semiconductor substrate (1) by means of a silicon oxide layer (8);

where said system is configured in such a way that, when the MOS transistor (9) is turned on, an amount of electrons/holes passes, for thermodynamic effect, from the well doped n/p (7) constituting the drain of said MOS transistor (9) to said second zone doped n/p (22) of said electrons/holes gathering well (2), so that the amount of electrons/holes in said well doped n/p (7) is decreased of the same amount of electrons/holes, and that, regardless of the fact that said MOS transistor (9) is turned on, at least a part of said amount of electrons/holes passes, for thermodynamic effect, from said second zone doped n/p (22) to said first zone doped n/p (21) of said electrons/holes gathering well (2).

11. System according to the preceding claim, **characterized in that** the drain of said MOS transistor (9) is connected to a first device or potential restoring device (D1), configured to restore the amount of electrons/holes in said electron/electrons gathering well (2), and to a second device or potential variation reading device (D2), configured to read the potential variation between said well doped n/p (7) and said ground, and **in that** said first device (D1) and said second device (D2) are controlled by a control and processing unit (19), configured to periodically read said potential variation through said second device (D2) and restore the amount of electrons/holes in said electrons/holes gathering well (2) through said first device (D1); said control and processing unit (19) being connected with said second device (D2).

12. System according to the preceding claim, **characterized in that**

said first device (D1) comprises a MOS transistor (14), powered by a first voltage ($V_{low}$),

**in that**

said second device (D2) comprises a first MOS transistor (15), powered by a second voltage ($V_{dd}$), where said second voltage ($V_{dd}$) is in absolute value greater than said first voltage ($V_{low}$), and a second MOS transistor (16), where the drain of said second MOS transistor (16) is connected to the source of said first MOS transistor (15) and the source of said second MOS transistor (16) is connected to said control and processing unit (19) via a bus (17), and **in that**

the drain of said MOS transistor (9), composed of said well doped n/p (7), is connected to the source of said MOS transistor (14) of said first device (D1) and to the gate of said first MOS transistor (15) of said second device (D2).

13. System according to any one of claims 10-12, **characterized in that** said second area doped n/p (22) has a doping between $10^{17}$ and $10^{19}$ cm$^{-3}$

14. System according to any one of claims 10-13, **characterized in that** said well doped n/p (7) constituting the drain of said MOS transistor (9) has a doping between $10^{17}$ and $10^{19}$ cm$^{-3}$.

15. System according to any one of claims 10-14, **characterized in that**:

said system comprises a first metal layer (21), on which a terminal (31) is arranged to allow a microwave generator (30) to be applied, and a plurality of second metal layers (22), on each of which a respective terminal (32), connected to said ground, is arranged; said first metal layer (21) and said second metal layers (22) being arranged on a dielectric layer (12), said dielectric layer being arranged on said semiconductor substrate (1),

**in that**

said first metal layer (21) is connected, through a first metallic element (M1), to said metal end surface (41), and each of said second metal layers (22) is connected, through a respective second metallic element (M2), to a respective ohmic contact (24), arranged in contact with said layer doped p/n (3), and

**in that**

said system comprises a further ohmic contact (25), arranged in contact with the well doped n/p (7) constituting the drain of said MOS transistor (9), on which a further terminal (34) is arranged to allow the application of a current meter (40) for measuring the current due to the passage of electrons/holes from said well doped n/p (7) towards said electrons/holes gathering well (2), when said MOS transistor (9) is turned on.

**Patentansprüche**

1. Gleichrichter für einen Sensor eines elektromagnetischen Signals, wobei das elektromagnetische Signal eine Frequenz zwischen 300 GHz und 10 THz aufweist, wobei der Gleichrichter umfasst:

- ein p/n dotiertes Halbleitersubstrat (1), das einen Elektronen/Löcher-Sammelschacht (2) zum Sammeln von Elektronen/Löchern umfasst; wobei der Elektronen/Löcher-Sammelschacht (2) im Inneren des Halbleitersubstrats (1) angeordnet ist und mindestens eine erste n/p dotierte Zone (21) umfasst; wobei die erste n/p dotierte Zone (21) eine Endfläche (21A) aufweist;
- eine Metall-Endfläche (41) einer Antenne (4), wobei die Antenne in der Lage ist, das elektromagnetische Signal zu empfangen und zu konzentrieren;
- eine p/n dotierte Schicht (3), die eine erste Fläche (31) und eine der ersten Fläche (31) gegenüberliegende zweite Fläche (32) aufweist;

wobei:

ein erster Abschnitt der ersten Fläche (31) der p/n dotierten Schicht (3) mit der Endfläche (21A) der ersten n/p dotierten Zone (21) des Elektronen/Löcher-Sammelschachts (2) in Kontakt ist, sodass ein erster metallurgischer Übergang (G1) gebildet wird, und

ein erster Abschnitt der zweiten Fläche (32) der p/n dotierten Schicht (3) mit der Metall-Endfläche (41) in Kontakt ist, sodass ein zweiter metallurgischer Übergang (G2) gebildet wird;

wobei die Konzentration der Dotierung der p/n dotierten Schicht (3) und die Konzentration der Dotierung der ersten n/p dotierten Zone (21) des Elektronen/Löcher-Sammelschachts (2) derart sind, dass der erste metallurgische Übergang (G1) eine erste Potentialbarriere ($V_{Z1}$) im Inneren aufweist, und die Austrittsarbeit des Metalls der Metall-Endfläche (41) derart ausgewählt ist, dass sie derjenigen eines n/p dotierten Halbleiters gleich ist, und derart, dass der zweite metallurgische Übergang (G2) eine zweite Potentialbarriere ($V_{Z2}$) im Inneren aufweist;
dadurch, dass

der erste metallurgische Übergang (G1) und der zweite metallurgische Übergang (G2) einen zweifachen metallurgischen Übergang n-p-n/p-n-p mit einer zweifachen Potentialbarriere bilden, die aus der ersten Potentialbarriere ($V_{Z1}$) und der zweiten Potentialbarriere ($V_{Z2}$) besteht, wobei der zweifache metallurgische Übergang n-p-n/p-n-p eine erste Verarmungszone (Z1) und eine zweite Verarmungszone (Z2) umfasst, die entlang einer innerhalb der p/n dotierten Schicht (3) disponierten Kontaktlinie (A) mit der ersten Verarmungszone (Z1) in Kontakt sind, wobei die erste Verarmungszone (Z1) eine Dicke aufweist, die größer ist als die Dicke der zweiten Verarmungszone (Z2); wobei die erste Potentialbarriere ($V_{Z1}$) mit der ersten Verarmungszone (Z1) verknüpft ist, und die zweite Potentialbarriere ($V_{Z2}$) mit der zweiten Verarmungszone (Z2) verknüpft ist;
dadurch, dass

die p/n dotierte Schicht (3) in einer derartigen Weise bemessen ist, dass die zweifache Potentialbarriere einen derartigen Wert aufweist, dass es der p/n dotierten Schicht (3) ermöglicht wird, vollständig von Löchern/Elektronen beraubt zu werden, sodass wenn durch das von der Antenne (4) empfangene elektromagnetische Signal ein veränderliches elektrisches Feld induziert wird, der zweifache metallurgische Übergang n-p-n/p-n-p einem veränderlichen elektrischen Feld unterworfen wird, und eine erste Potentialdifferenz ($\Delta V_{Z1}$) und eine zweite Potentialdifferenz ($\Delta V_{Z2}$) jeweils über die erste Verarmungszone (Z1) und über die zweite Verarmungszone (Z2) erzeugt werden, wobei jede Potentialdifferenz ($\Delta V_{Z1}$, $\Delta V_{Z2}$) zur Dicke der jeweiligen Verarmungszone (Z1, Z2) proportional ist und algebraisch zur jeweiligen Potentialbarriere ($V_{Z1}$, $V_{Z2}$) addiert wird, sodass

wenn die erste Potentialdifferenz ($\Delta V_{Z1}$) negativ/positiv ist, die erste Potentialbarriere ($V_{Z1}$) im absoluten Wert um einen Wert reduziert wird, der gleich der ersten Potentialdifferenz ($\Delta V_{Z1}$) ist, und sich ein erster Betrag von Elektronen/Löchern in eine erste Richtung von der ersten n/p dotierten Zone (21) des Elektronen/Löcher-Sammelschachts (2) zur Metall-Endfläche (41) bewegt, und

wenn die zweite Potentialdifferenz ($\Delta V_{Z2}$) positiv/negativ ist, die zweite Potentialbarriere ($V_{Z2}$) im absoluten Wert um einen Wert reduziert wird, der gleich der zweiten Potentialdifferenz ($\Delta V_{Z2}$) ist, und sich ein zweiter Betrag von Elektronen/Löchern in eine der ersten Richtung gegenüberliegende zweite Richtung von der Metall-Endfläche (41) zur ersten n/p dotierten Zone (21) des Elektronen/Löcher-Sammelschachts (2) bewegt;

die Austrittsarbeit des Metalls der Metall-Endfläche (41) und die Konzentrationen der Dotierung der p/n dotierten Schicht (3) und der ersten n/p dotierten Zone (21) derart sind, dass die Verarmungszonen (Z1, Z2) asymmetrisch verformt werden und dass sich der erste Betrag von Elektronen/Löchern von dem zweiten Betrag von Elektronen/Löchern unterscheidet, sodass ein kontinuierlicher elektrischer Strom erzeugt wird, der von dem von der Antenne (4) empfangenen elektromagnetischen Signal induziert wird.

2. Gleichrichter nach dem vorstehenden Anspruch, **dadurch gekennzeichnet, dass** der zweite metallurgische Übergang (G2) in einer derartigen Weise bemessen ist, dass seine orthogonale Projektion auf die erste Fläche (31) der p/n dotierten Schicht (3) im ersten metallurgischen Übergang (G1) enthalten ist.

3. Gleichrichter nach einem der vorstehenden Ansprüche, **dadurch gekennzeichnet, dass** die erste Verarmungszone (Z1) einen ersten Abschnitt umfasst, der sich von der ersten Fläche (31) der p/n dotierten Schicht (3) im Inneren der ersten n/p dotierten Zone (21) des Elektronen/Löcher-Sammelschachts (2) erstreckt, und einen zweiten Abschnitt, der sich von der ersten Fläche (31) der p/n dotierten Schicht (3) im Inneren der p/n dotierten Schicht (3) selbst bis zur Kontaktlinie (A) erstreckt, und dadurch, dass sich die zweite Verarmungszone (Z2) im Wesentlichen von der zweiten Fläche (32) der p/n dotierten Schicht (3) zum Inneren der p/n dotierten Schicht (3) bis zur Kontaktlinie (A) hin erstreckt.

4. Gleichrichter nach einem der vorstehenden Ansprüche, **dadurch gekennzeichnet, dass** die Austrittsarbeit des Metalls der Metall-Endfläche (41) einen Wert zwischen 4,2-4,4 eV aufweist.

5. Gleichrichter nach einem der vorstehenden Ansprüche, **dadurch gekennzeichnet, dass** das Metall der Metall-Endfläche (41) aus der folgenden Gruppe von Metallen ausgewählt ist: Titan, Molybdän, Bismut, Vanadium.

6. Gleichrichter nach einem der vorstehenden Ansprüche, **dadurch gekennzeichnet, dass** eine dielektrische Schicht zwischen der Metall-Endfläche (41) und der zweiten Fläche (32) der p/n dotierten Schicht (3) zwischengefügt ist, um die Leitung zwischen der Metall-Endfläche (41) und der p/n dotierten Schicht (3) sicherzustellen, und um die Position des Fermi-Niveaus der Metall-Endfläche (41) bis zum physischen Kontakt mit dem zweiten metallurgischen Übergang (G2) aufrecht zu erhalten.

7. Gleichrichter nach dem vorstehenden Anspruch, **dadurch gekennzeichnet, dass** die dielektrische Schicht eine Siliziumoxidschicht ist; wobei das Silizium eine Atomkonzentration zwischen 35 % und 45 % aufweist.

8. Gleichrichter nach einem der vorstehenden Ansprüche, **dadurch gekennzeichnet, dass** die erste n/p dotierte Zone (21) des Elektronen/Löcher-Sammelschachts (2) eine Dotierung zwischen $10^{15}$ und $10^{17}$ cm$^{-3}$ aufweist.

9. Gleichrichter nach einem der vorstehenden Ansprüche, **dadurch gekennzeichnet, dass** die p/n dotierte Schicht (3) eine Dotierung zwischen $10^{17}$ und $10^{19}$ cm$^{-3}$ aufweist.

10. Ladungssammelsystem, das einen Gleichrichter nach einem der vorstehenden Ansprüche umfasst, **dadurch gekennzeichnet, dass** das Halbleitersubstrat (1) mit einer Masse verbunden ist und dadurch, dass der Elektronen/Löcher-Sammelschacht (2) des Gleichrichters eine zweite n/p dotierte Zone (22) umfasst, die in Kontakt mit der ersten n/p dotierten Zone (21) angeordnet ist, wobei die zweite n/p dotierte Zone (22) eine Dotierung aufweist, die höher ist als die Dotierung der ersten n/p dotierten Zone (21); wobei das System weiter umfasst:

einen MOS-Transistor (9), der dazu ausgebildet ist, Elektronen/Löcher in den Elektronen/Löcher-Sammelschacht (2) einzubringen; wobei der MOS-Transistor (9) eine Senke aufweist, die aus einem n/p dotierten Schacht (7) besteht, welcher innerhalb des Halbleitersubstrats (1) disponiert ist, eine Quelle, die aus mindestens einem Endabschnitt (221) der zweiten n/p dotierten Zone (22) des Elektronen/Löcher-Sammelschachts (2) besteht, und ein Gatter, das rittlings zwischen der Senke und der Quelle disponiert und mittels einer Siliziumoxidschicht (8) vom Halbleitersubstrat (1) getrennt ist; wobei das System in einer derartigen Weise konfiguriert ist, dass wenn der MOS-Transistor (9) eingeschaltet ist, ein Betrag von Elektronen/Löchern für thermodynamischen Effekt vom n/p dotierten Schacht (7), der die Senke des MOS-Transistors (9) darstellt, zu der zweiten n/p dotierten Zone (22) des Elektronen/Löcher-Sammelschachts (2) wandert, sodass der Betrag von Elektronen/Löchern im n/p dotierten Schacht (7) um den gleichen Betrag von Elektronen/Löchern verringert wird, und dass ungeachtet der Tatsache, dass der MOS-Transistor (9) eingeschaltet ist, mindestens ein Teil des Betrages von Elektronen/Löchern für thermodynamischen Effekt von der zweiten n/p dotierten Zone (22) zu der ersten n/p dotierten Zone (21) des Elektronen/Löcher-Sammelschachts (2) wandert.

11. System nach dem vorstehenden Anspruch, **dadurch gekennzeichnet, dass** die Senke des MOS-Transistors (9) mit einer ersten Vorrichtung oder Potential-Wiederherstellungsvorrichtung (D1) verbunden ist, die dazu konfiguriert ist, den Betrag von Elektronen/Löchern im Elektron/Elektronen-Sammelschacht (2) wiederherzustellen, und mit einer zweiten Vorrichtung oder Potentialschwankungs-Messvorrichtung (D2), die dazu konfiguriert ist, die Potentialschwankung zwischen dem n/p dotierten Schacht (7) und der Masse zu messen, und dadurch, dass die erste Vorrichtung (D1) und die zweite Vorrichtung (D2) von einer Steuerungs- und Verarbeitungseinheit (19) gesteuert werden, die dazu konfiguriert ist, die Potentialschwankung periodisch über die zweite Vorrichtung (D2) zu messen und den Betrag von Elektronen/Löchern im Elektronen/Löcher-Sammelschacht (2) über die erste Vorrichtung (D1) wieder herzustellen; wobei die Steuerungs- und Verarbeitungseinheit (19) mit der zweiten Vorrichtung (D2) verbunden ist.

12. System nach dem vorstehenden Anspruch, **dadurch gekennzeichnet, dass**
die erste Vorrichtung (D1) einen MOS-Transistor (14) umfasst, der von einer ersten Spannung ($V_{low}$) gespeist wird,
dadurch, dass
die zweite Vorrichtung (D2) einen ersten MOS-Transistor (15) umfasst, der von einer zweiten Spannung ($V_{dd}$) gespeist wird, wobei die zweite Spannung ($V_{dd}$) im absoluten Wert größer ist als die erste Spannung ($V_{low}$), und einen zweiten MOS-Transistor (16), wobei die Senke des zweiten MOS-Transistors (16) mit der Quelle des ersten MOS-Transistors (15) verbunden ist, und die Quelle des zweiten MOS-Transistors (16) über einen Bus (17) mit der Steuerungs- und Verarbeitungseinheit (19) verbunden ist, und dadurch, dass
die Senke des MOS-Transistors (9), die aus dem n/p dotierten Schacht (7) besteht, mit der Quelle des MOS-Transistors (14) der ersten Vorrichtung (D1) und mit dem Gatter des ersten MOS-Transistors (15) der zweiten Vorrichtung (D2) verbunden ist.

13. System nach einem der Ansprüche 10 bis 12, **dadurch gekennzeichnet, dass** der zweite n/p dotierte Bereich (22) eine Dotierung zwischen $10^{17}$ und $10^{19}$ cm$^{-3}$ aufweist.

14. System nach einem der Ansprüche 10 bis 13, **dadurch gekennzeichnet, dass** der n/p dotierte Schacht (7), der die Senke des MOS-Transistors (9) darstellt, eine Dotierung zwischen $10^{17}$ und $10^{19}$ cm$^{-3}$ aufweist.

15. System nach einem der Ansprüche 10 bis 14, **dadurch gekennzeichnet, dass**:

    das System eine erste Metallschicht (21) umfasst, auf der ein Anschluss (31) angeordnet ist, um zu ermöglichen, dass ein Mikrowellengenerator (30) angelegt wird, und eine Vielzahl von zweiten Metallschichten (22), auf jeder von denen ein jeweiliger, mit der Masse verbundener Anschluss (32) angeordnet ist; wobei die erste Metallschicht (21) und die zweiten Metallschichten (22) auf einer dielektrischen Schicht (12) angeordnet sind, wobei die dielektrische Schicht auf dem Halbleitersubstrat (1) angeordnet ist, dadurch, dass
    die erste Metallschicht (21) über ein erstes metallisches Element (M1) mit der Metall-Endfläche (41) verbunden ist, und jede der zweiten Metallschichten (22) über ein jeweiliges zweites metallisches Element (M2) mit einem jeweiligen ohmschen Kontakt (24) verbunden ist, der in Kontakt mit der p/n dotierten Schicht (3) angeordnet ist, und dadurch, dass
das System einen weiteren ohmschen Kontakt (25) umfasst, der in Kontakt mit dem n/p dotierten Schacht (7) angeordnet ist, welcher die Senke des MOS-Transistors (9) darstellt, auf welchem ein weiterer Anschluss (34) angeordnet ist, um das Anlegen eines Strommessers (40) zum Messen des Stroms zu ermöglichen, der durch die Wanderung von Elektronen/Löchern von dem n/p dotierten Schacht (7) zu dem Elektronen/Löcher-Sammelschacht (2) hin bedingt wird, wenn der MOS-Transistor (9) eingeschaltet ist.

**Revendications**

1. Redresseur pour un capteur de signal électromagnétique, ledit signal électromagnétique ayant une fréquence entre 300 GHz et 10 THz, ledit redresseur comprenant:

    - un substrat semiconducteur (1) dopé p/n comprenant un puits de collecte d'électrons/de trous (2) servant à collecter des électrons/des trous, ledit puits de collecte d'électrons/de trous (2) étant agencé à l'intérieur dudit substrat semiconducteur (1) et comprenant au moins une première zone dopée n/p (21) ; ladite première zone dopée n/p (21) présentant une surface d'extrémité (21A) ;
    - une surface d'extrémité métallique (41) d'une antenne (4), ladite antenne étant capable de recevoir et de concentrer ledit signal électromagnétique ;
    - une couche dopée p/n (3) présentant une première surface (31) et une seconde surface (32), opposée à ladite première surface (31) ;

    dans lequel :

    une première partie de ladite première surface (31) de ladite couche dopée p/n (3) est en contact avec ladite surface d'extrémité (21A) de ladite première zone dopée n/p (21) du puits de collecte d'électrons/de trous (2), de manière à former une première jonction métallurgique (G1), et
    une première partie de ladite seconde surface (32) de ladite couche dopée p/n (3) est en contact avec ladite surface d'extrémité métallique (41), de manière à former une seconde jonction métallurgique (G2) ;

où la concentration du dopage de ladite couche dopée p/n (3) et la concentration du dopage de ladite première zone dopée n/p (21) dudit puits de collecte d'électrons/de trous (2) sont telles que ladite première jonction métallurgique (G1) présente une première barrière de potentiel ($V_{Z1}$) à l'intérieur et la fonction de travail du métal de ladite surface d'extrémité métallique (41) est sélectionnée de telle sorte qu'elle est égale à celle d'un semi-conducteur dopé n/p et de telle sorte que ladite seconde jonction métallurgique (G2) présente une seconde barrière de potentiel ($V_{z2}$) à l'intérieur ;

en ce que

ladite première jonction métallurgique (G1) et ladite seconde jonction métallurgique (G2) forment une double jonction métallurgique n-p-n/p-n-p avec une double barrière de potentiel composée de ladite première barrière de potentiel ($V_{Z1}$) et de ladite seconde barrière de potentiel ($V_{z2}$), où ladite double jonction métallurgique n-p-n/p-n-p comprend une première zone d'appauvrissement (Z1), et une seconde zone d'appauvrissement (Z2), en contact avec ladite première zone d'appauvrissement (Z1) le long d'une ligne de contact (A), disposée à l'intérieur de ladite couche dopée p/n (3), ladite première zone d'appauvrissement (Z1) présentant une épaisseur supérieure à l'épaisseur de la seconde zone d'appauvrissement (Z2) ; ladite première barrière de potentiel ($V_{Z1}$) étant associée à ladite première zone d'appauvrissement (Z1), et ladite seconde barrière de potentiel ($V_{z2}$) étant associée à ladite seconde zone d'appauvrissement (Z2) ;

en ce que

ladite couche dopée p/n (3) est dimensionnée de telle sorte que ladite double barrière de potentiel a une valeur telle que cela permet à ladite couche dopée p/n (3) d'être complètement dépourvue de trous/d'électrons, de sorte que, lorsqu'un champ électrique variable est induit par ledit signal électromagnétique reçu par ladite antenne (4), ladite double jonction métallurgique n-p-n/p-n-p est soumise audit champ électrique variable, et une première différence de potentiel ($\Delta V_{Z1}$) et une seconde différence de potentiel ($\Delta V_{Z2}$) sont générées, à travers la première zone d'appauvrissement (Z1) et à travers la seconde zone d'appauvrissement (Z2) respectivement, où chaque différence de potentiel ($\Delta V_{Z1}$, $\Delta V_{Z2}$) est proportionnelle à l'épaisseur de la zone d'appauvrissement (Z1, Z2) respective et est ajoutée algébriquement à la barrière de potentiel ($V_{Z1}$, $V_{Z2}$) respective de sorte que lorsque ladite première différence de potentiel ($\Delta V_{Z1}$) est négative/positive, la première barrière de potentiel ($V_{Z1}$) est réduite en valeur absolue d'une valeur égale à la première différence de potentiel ($\Delta V_{Z1}$) et une première quantité d'électrons/de trous se déplace dans une première direction, depuis la première zone dopée n/p (21) du puits de collecte d'électrons/de trous (2) jusqu'à la surface d'extrémité métallique (41), et

lorsque ladite seconde différence de potentiel ($\Delta V_{Z2}$) est positive/négative, la seconde barrière de potentiel ($V_{Z2}$) est réduite en valeur absolue d'une valeur égale à la seconde différence de potentiel ($\Delta V_{Z2}$) et une seconde quantité d'électrons/de trous se déplace dans une seconde direction, opposée à la première direction, depuis la surface d'extrémité métallique (41) jusqu'à la première zone dopée n/p (21) du puits de collecte d'électrons/de trous (2) ;

la fonction de travail du métal de ladite surface d'extrémité métallique (41) et les concentrations du dopage de ladite couche dopée p/n (3) et de ladite première zone dopée n/p (21) étant telles que lesdites zones d'appauvrissement (Z1, Z2) sont déformées asymétriquement et que ladite première quantité d'électrons/de trous est différente de ladite seconde quantité d'électrons/de trous, de façon à générer un courant électrique continu induit par ledit signal électromagnétique reçu par ladite antenne (4).

2. Redresseur selon la revendication précédente, **caractérisé en ce que** ladite seconde jonction métallurgique (G2) est dimensionnée de telle sorte que sa projection orthogonale sur ladite première surface (31) de la couche dopée p/n (3) est contenue dans la première jonction métallurgique (G1).

3. Redresseur selon l'une quelconque des revendications précédentes, **caractérisé en ce que** ladite première zone d'appauvrissement (Z1) comprend une première partie s'étendant depuis ladite première surface (31) de ladite couche dopée p/n (3) à l'intérieur de ladite première zone dopée n/p (21) dudit puits de collecte d'électrons/de trous (2), et une seconde partie s'étendant depuis ladite première surface (31) de ladite couche dopée p/n (3) à l'intérieur de la couche dopée p/n (3) elle-même, jusqu'à ladite ligne de contact (A), et **en ce que** ladite seconde zone d'appauvrissement (Z2) s'étend sensiblement depuis ladite seconde surface (32) de ladite couche dopée p/n (3) vers l'intérieur de ladite couche dopé p/n (3), jusqu'à ladite ligne de contact (A).

4. Redresseur selon l'une quelconque des revendications précédentes, **caractérisé en ce que** la fonction de travail du métal de ladite surface d'extrémité métallique (41) a une valeur entre 4,2-4,4 eV.

5. Redresseur selon l'une quelconque des revendications précédentes, **caractérisé en ce que** le métal de ladite surface d'extrémité métallique (41) est sélectionné parmi le groupe de métaux suivant : titane, molybdène, bismuth, vanadium.

6. Redresseur selon l'une quelconque des revendications précédentes, **caractérisé en ce qu'**une couche diélectrique est interposée entre la surface d'extrémité métallique (41) et la seconde surface (32) de ladite couche dopée p/n (3), afin d'assurer la conduction entre ladite surface d'extrémité métallique (41) et ladite couche dopée p/n (3), et de maintenir la position du niveau de Fermi de ladite surface d'extrémité métallique (41) jusqu'au contact physique avec ladite seconde jonction métallurgique (G2).

7. Redresseur selon la revendication précédente, **caractérisé en ce que** ladite couche diélectrique est une couche d'oxyde de silicium ; ledit silicium ayant une concentration atomique entre 35 % et 45 %.

8. Redresseur selon l'une quelconque des revendications précédentes **caractérisé en ce que** ladite première zone dopée n/p (21) dudit puit de collecte d'électrons/de trous (2) a un dopage entre $10^{15}$ et $10^{17}$ cm$^{-3}$.

9. Redresseur selon l'une quelconque des revendications précédentes, **caractérisé en ce que** ladite couche dopée p/n (3) a un dopage entre $10^{17}$ et $10^{19}$ cm$^{-3}$.

10. Système de collecte de charge comprenant un redresseur selon l'une quelconque des revendications précédentes, **caractérisé en ce que** ledit substrat semi-conducteur (1) est connecté à une masse et **en ce que** le puits de collecte d'électrons/de trous (2) dudit redresseur comprend une seconde zone dopée n/p (22), agencée en contact avec ladite première zone dopée n/p (21), où ladite seconde zone dopée n/p (22) a un dopage supérieur au dopage de ladite première zone dopée n/p (21) ;
ledit système comprenant en outre :

un transistor MOS (9) adapté pour introduire des électrons/des trous dans ledit puits de collecte d'électrons/de trous (2) ; ledit transistor MOS (9) ayant un drain consistant en un puits dopé n/p (7), disposé dans ledit substrat semi-conducteur (1), une source consistant en au moins une partie d'extrémité (221) de ladite seconde zone dopée n/p (22) dudit puits de collecte d'électrons/de trous (2), et une grille disposée à cheval entre ledit drain et ladite source et séparée dudit substrat semi-conducteur (1) à travers une couche d'oxyde de silicium (8) ;
où ledit système est configuré de telle sorte que, lorsque le transistor MOS (9) est allumé, une quantité d'électrons/de trous passe, pour l'effet thermodynamique, depuis le puits dopé n/p (7) constituant le drain dudit transistor MOS (9) jusqu'à ladite seconde zone dopée n/p (22) dudit puits de collecte d'électrons/de trous (2), de sorte que la quantité d'électrons/de trous dans ledit puits dopé n/p (7) est diminuée de la même quantité d'électrons/de trous, et que, indépendamment du fait que ledit transistor MOS (9) soit allumé, au moins une partie de ladite quantité d'électrons/de trous passe, pour l'effet thermodynamique, depuis ladite seconde zone dopée n/p (22) jusqu'à ladite première zone dopée n/p (21) dudit puits de collecte d'électrons/de trous (2).

11. Système selon la revendication précédente, **caractérisé en ce que** le drain dudit transistor MOS (9) est connecté à un premier dispositif ou dispositif de restauration de potentiel (D1), configuré pour restaurer la quantité d'électrons/de trous dans ledit puits de collecte d'électron/électrons (2), et à un second dispositif ou dispositif de lecture de variation de potentiel (D2), configuré pour lire la variation de potentiel entre ledit puits dopé n/p (7) et ladite masse, et **en ce que** ledit premier dispositif (D1) et ledit second dispositif (D2) sont commandés par une unité de commande et de traitement (19), configurée pour lire périodiquement ladite variation de potentiel à travers ledit second dispositif (D2) et restaurer la quantité d'électrons/de trous dans ledit puits de collecte d'électrons/de trous (2) à travers ledit premier dispositif (D1); ladite unité de commande et de traitement (19) étant connectée audit second dispositif (D2).

12. Système selon la revendication précédente, **caractérisé en ce que**
ledit premier dispositif (D1) comprend un transistor MOS (14), alimenté par une première tension ($V_{basse}$),
**en ce que**
ledit second dispositif (D2) comprend un premier transistor MOS (15), alimenté par une seconde tension ($V_{dd}$), où ladite seconde tension ($V_{dd}$) est en valeur absolue supérieure à ladite première tension ($V_{basse}$), et un second transistor MOS (16), où le drain dudit second transistor MOS (16) est connecté à la source dudit premier transistor MOS (15) et la source dudit second transistor MOS (16) est connectée à ladite unité de commande et de traitement (19) par un bus (17), et
**en ce que**
le drain dudit transistor MOS (9), composé dudit puits dopé n/p (7), est connecté à la source dudit transistor MOS (14) dudit premier dispositif (D1) et à la grille dudit premier transistor MOS (15) dudit second dispositif (D2).

**13.** Système selon l'une quelconque des revendications 10 à 12, **caractérisé en ce que** ladite seconde zone dopée n/p (22) a un dopage entre $10^{17}$ et $10^{19}$ cm$^{-3}$

**14.** Système selon l'une quelconque des revendications 10 à 13, **caractérisé en ce que** ledit puits dopé n/p (7) constituant le drain dudit transistor MOS (9) a un dopage entre $10^{17}$ et $10^{19}$ cm$^{-3}$.

**15.** Système selon l'une quelconque des revendications 10 à 14, **caractérisé en ce que** :

ledit système comprend une première couche métallique (21), sur laquelle une borne (31) est agencée pour permettre à un générateur de micro-ondes (30) d'être appliqué, et une pluralité de secondes couches métalliques (22), sur chacune desquelles une borne respective (32), connectée à ladite masse, est agencée ; ladite première couche métallique (21) et lesdites secondes couches métalliques (22) étant agencées sur une couche diélectrique (12), ladite couche diélectrique étant agencée sur ledit substrat semi-conducteur (1),

**en ce que**

ladite première couche métallique (21) est connectée, à travers un premier élément métallique (M1), à ladite surface d'extrémité métallique (41), et chacune desdites secondes couches métalliques (22) est connectée, à travers un second élément métallique respectif (M2), à un contact ohmique respectif (24), agencé en contact avec ladite couche dopée n/p (3), et

**en ce que**

ledit système comprend un autre contact ohmique (25), agencé en contact avec le puits dopé n/p (7) constituant le drain dudit transistor MOS (9), sur lequel une autre borne (34) est agencée pour permettre l'application d'un ampèremètre (40) pour mesurer le courant dû au passage d'électrons/de trous depuis ledit puits dopé n/p (7) vers ledit puits de collecte d'électrons/de trous (2), quand ledit transistor MOS (9) est allumé.

Fig. 1

Fig. 2

Fig. 3

Fig. 4

Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 20110096447 A